**Europäisches Patentamt**

**European Patent Office**

(19) **Office européen des brevets**

(11) Veröffentlichungsnummer : **0 398 120 B1**

(12) **EUROPÄISCHE PATENTSCHRIFT**

(45) Veröffentlichungstag der Patentschrift :
**13.10.93 Patentblatt 93/41**

(51) Int. Cl.⁵ : **H01L 29/32**, H01L 21/263,
H01L 21/324, H01L 21/22

(21) Anmeldenummer : **90108577.9**

(22) Anmeldetag : **07.05.90**

(54) **Halbleiterbauelement.**

(30) Priorität : **18.05.89 CH 1861/89**

(43) Veröffentlichungstag der Anmeldung :
**22.11.90 Patentblatt 90/47**

(45) Bekanntmachung des Hinweises auf die
Patenterteilung :
**13.10.93 Patentblatt 93/41**

(84) Benannte Vertragsstaaten :
**CH DE FR GB IT LI SE**

(56) Entgegenhaltungen :
**EP-A- 0 014 516**
**GB-A- 1 124 176**

(56) Entgegenhaltungen :
**PATENT ABSTRACTS OF JAPAN, Band 1, Nr.
52, 20. Mai 1977, Seite 3437 E 76; & JP-A-51 147
978**
**SOLID-STATE ELECTRONICS, Band 30, Nr. 2,
Februar 1987, Seiten 185-188, Pergamon Journals Ltd, GB; A. MOGRO-CAMPERO et al.:
"Temperature behavior and annealing of insulated gate transistors subjected to localized
lifetime control by proton implantation"**

(73) Patentinhaber : **ASEA BROWN BOVERI AG**
**Haselstrasse**
**CH-5401 Baden (CH)**

(72) Erfinder : **Hüppi, Marcel, Dr.**
**Schrennengasse 9**
**CH-8003 Zürich (CH)**

## Beschreibung

## Technisches Gebiet

Die Erfindung betrifft ein Halbleiterbauelement, welches von einem leitenden in einen nichtleitenden Zustand schalten kann, umfassend eine dotierte Zone mit Minoritätsladungsträgern, welche im nichtleitenden Zustand eine gegebene mittlere Volumenlebensdauer $Tau_{SRH}$ und damit eine mittlere Volumendiffusionslänge $L_{D,Bulk}$ haben und im leitenden Zustand, bei welchem die dotierte Zone mit Minoritätsladungsträgern in einer axialen Richtung überschwemmt wird, eine aufgrund der Auger-Rekombination verkürzte Lebensdauer $Tau_{Aug}$ haben, und einen axial begrenzten Bereich in der dotierten Zone, in welchem Rekombinationszentren zum Reduzieren der mittleren Volumenlebensdauer $Tau_{SRH}$ der Minoritätsladungsträger vorhanden sind.

## Stand der Technik

Es ist bekannt, dass eine Reduktion der Ladungsträger-Lebensdauer zur Verbesserung der Schaltzeit eines Leistungs-Halbleiterbauelements führt. Eine in diesem Sinn gezielte Einstellung der Ladungsträger-Lebensdauer in einem Halbleiterbauelement kann einerseits durch Eindiffusion von Fremdatomen (z.B. Au oder Pt) und andererseits durch Bestrahlung mit Protonen oder Elektronen erreicht werden.

Sowohl die Eindiffusion von Fremdatomen als auch die Elektronenbestrahlung führen zu einer über das ganze Bauelement hinweg relativ homogenen Lebensdauerreduktion. Im Gegensatz zu den Diffusionsverfahren ist die Elektronenbestrahlung aber hinreichend gut reproduzierbar.

Mit der Protonenbestrahlung wird ein längs der stromführenden Achse (axiale Richtung) pulsförmiges Konzentrationsprofil von Rekombinationszentren erzeugt. Durch geeignetes Tempern nach der Bestrahlung kann die Effizienz der Rekombinationszentren ausserdem so stark gesteigert werden, dass dieses Verfahren insgesamt deutliche Vorteile gegenüber der Au-Diffusion aufweist (siehe z.B. "Protonenbestrahlung von Silizium", M. W. Hüppi, Diss. ETH No. 8755, S. 100-110, 1989).

Alle Methoden zur Einstellung der Ladungsträger-Lebensdauer sind inhärent mit dem Nachteil behaftet, dass man zwar durch Reduktion der Ladungsträger-Lebensdauer kürzere Schaltzeiten erreicht, aber dafür einen höheren Vorwärtsspannungsabfall (Verlustleistung im leitenden Zustand) in Kauf nehmen muss. Es ist bekannt (siehe z.B. "Shorter Turn-off Times in Insulated Gate Transistors by Proton Implantation", A. Mogro-Campero et al., IEEE Electron Device Letters, Vol. EDL-6, No. 5, May 1985), dass die Protonenbestrahlung in Bezug auf die Optimierung dieses Trade-offs der Elektronenbestrahlung überlegen ist. Dies kann damit begründet werden, dass bei der Protonenbestrahlung zur Einstellung der Lebensdauer der Freiheitsgrad in axialer Richtung des Bauelements (axiale Lebensdauerstrukturierung) zusätzlich genutzt wird. D.h. die Ladungsträger-Lebensdauer wird nur dort reduziert, wo es nötig und sinnvoll ist.

Aus der britischen Patentschrift GB 1,124,176 ist ein Halbleiterbauelement bekannt, welches Zonen mit Rekombinationszentren aufweist. Der Abstand zwischen zwei Zonen beträgt mindestens zweimal die Volumendiffusionslänge. Die Zonen reichen von der Bauteiloberfläche bis zu einer gewissen Tiefe. Sie durchdringen dabei sowohl die oberste $n^+$- als auch die darunterliegende p-Schicht. Ihre Wirkung ist deshalb mit derjenigen von Emittershorts zu vergleichen.

## Darstellung der Erfindung

Aufgabe der Erfindung ist es, ein Halbleiterbauelement der eingangs genannten Art anzugeben, bei welchem der Trade-off zwischen Vorwärtsspannungsabfall und Abschaltzeit insgesamt gegenüber dem Stand der Technik verbessert wird.

Erfindungsgemäss besteht die Lösung darin, dass bei einem Halbleiterbauelement der genannten Art die Rekombinationszentren ein quer zur axialen Richtung periodisch variierendes Trapdichteprofil bilden, bei welchen sich Abschnitte geringer Trapdichte mit Abschnitten hoher Trapdichte mit einer etwa der Volumendiffusionslänge $L_{D,Bulk}$ entsprechenden Periode abwechseln.

Gemäss einer bevorzugten Ausführungsform bilden die Rekombinationszentren ein zweidimensional periodisch variierendes Trapdichteprofil.

Ebenso entspricht es eine bevorzugten Ausführungsform, wenn das Trapdichteprofil in Abschnitten geringer Trapdichte und in Abschnitten hoher Trapdichte je näherungsweise einen konstant niedrigen resp. konstant hohen Wert annimmt und wenn es sich von Abschnitten geringer Trapdichte zu Abschnitten hoher Trapdichte sprunghaft ändert.

Im Hinblick auf die Effizienz setzt sich das Trapdichteprofil vorzugsweise flächenmässig aus etwa gleich grossen Abschnitte kleiner und grosser Dichte zusammen.

Soll die Erfindung die Schalteigenschaften eines PN-Ueberganges verbessern, so grenzt die dotierte Zone in axialer Richtung an eine hochdotierte, Minoritätsträger injizierende Zone und bildet mit dieser einen schnell schaltenden PN-Uebergang.

Aus den Unteransprüchen ergeben sich weitere vorteilhafte Ausführungsformen der Erfindung.

## Kurze Beschreibung der Zeichnung

Nachfolgend soll die Erfindung anhand von Ausführungsbeispielen im Zusammenhang mit der Zeichnung näher erläutert werden. Es zeigen:

Fig. 1  eine schematische Darstellung eines Halbleiterbauelements mit axial und lateral strukturiertem Trapdichteprofil;

Fig. 2  eine schematische Darstellung des Trapdichteprofils quer zur stromführenden Achse;

Fig. 3  eine Vorrichtung zum Erzeugen eines lateral und axial strukturierten Trapdichteprofils in einem Halbleiterbauelement;

Fig. 4  eine Blende mit einem periodischen Lochraster;

Fig. 5  eine Blende mit einem schachbrettartigen Lochraster; und

Fig. 6  eine Blende, bei welcher auf einem protonendurchlässigen Träger ein Muster mit protonenabsorbierendem Material angeordnete ist.

Die in der Zeichnung verwendeten Bezugszeichen und deren Bedeutung sind in der Bezeichnungsliste zusammenfassend tabelliert. Grundsätzlich sind gleiche Teile mit gleichen Bezugszeichen versehen.

## Wege zur Ausführung der Erfindung

Um die Beschreibung nicht unnötig zu komplizieren, wird die Erfindung zunächst am Beispiel einer Diode erläutert.

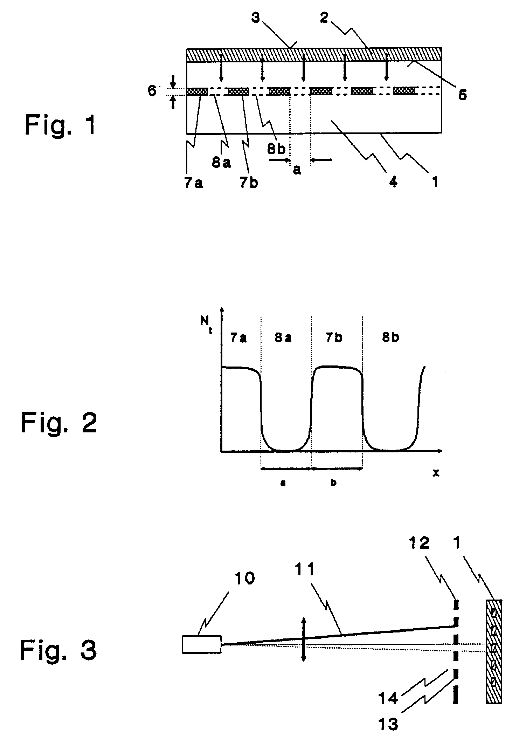

Fig. 1 zeigt ein Halbleiterbauelement, bei welchem zur Verkürzung der Abschaltzeit ein erfindungsgemässes Trapdichteprofil in den Halbleiterkörper eingebracht wurde.

Ein Halbleitersubstrat 1 weist in seinem Inneren ein einer Diode entsprechendes Diffusionsprofil auf. Eine hochdotierte Zone 2 dringt von einer ersten Hauptfläche 3 bis auf eine vorgegebene Tiefe in das Halbleitersubstrat 1 ein und bildet mit einer niedrigdotierten Zone 4, welche durch die Grunddotierung des Halbleitersubstrats 1 gebildet wird, einen PN-Uebergang 5. Im leitenden Zustand des Halbleiterbauelements injiziert die hochdotierte Zone 2 in einer axialen Richtung (senkrecht zum ebenen PN-Uebergang 5) Minoritätsladungsträger in die niedrigdotierte Zone 4. In Fig. 1 ist dies durch Pfeile angedeutet.

Die niedrigdotierte Zone 4 weist einen in geeigneter Tiefe angelegten, axial begrenzten Bereich 6 auf, in welchem Rekombinationszentren zur Reduktion der Ladungsträger-Lebensdauer angesiedelt sind. Die Rekombinationszentren bilden ein Trapdichteprofil, welches quer zur stromführenden Achse (also in einer Ebene senkrecht zur axialen Richtung) periodisch variiert. Es wechseln sich also Abschnitte hoher Trapdichte 7a, 7b,.. und Abschnitte niedriger Trapdichte 8a, 8b,.. gegenseitig ab. Die Abschnitte niedriger Trapdichte erstrecken sich senkrecht zur axialen Richtung über eine vorgegebene charakteristische Länge a.

Fig. 2 zeigt eine Darstellung eines Trapdichteprofils 9. Auf der Abszisse ist der Ort x quer zur stromführenden Achse und auf der Ordinate die Trapdichte $N_t$ aufgetragen. Das Trapdichteprofil 9 variiert periodisch. Die Abschnitte geringer Trapdichte erstrecken sich über eine wohl definierte Länge a.

Im folgenden wird nun erläutert, wie diese Länge a zu bemessen ist.

Wenn sich das Halbleiterbauelement in einem nichtleitenden Zustand (und im thermischen Gleichgewicht) befindet, haben die Minoritätsladungsträger in der niedrigdotierten Zone 4 (mit Ausnahme des axial begrenzten Bereichs 6) eine Volumenlebensdauer $Tau_{SRH}$, welche im wesentlichen durch den Ladungsträgereinfang an tiefen Störstellen bestimmt ist und sich mit dem bekannten Shockley-Read-Hall Modell ermitteln lässt. Dieser Volumenlebensdauer $Tau_{SRH}$ wird üblicherweise eine Volumendiffusionslänge $L_{D,bulk}$ gemäss

$$L_{D,bulk,i} = \sqrt{D_i\ Tau_{SRH,i}} \quad , \quad i = n\ (Elektron),\ p\ (Loch)$$
Typ des Minoritätsladungsträgers

$$D_i = Diffusionskonstante$$

zugeordnet. Bildlich gesprochen ist die Volumendiffusionslänge der Weg, den ein Minoritätsladungsträger im Mittel zurücklegt, bis er mit einem Majoritätsladungsträger in einem Rekombinationszentrum ("Trap") rekombiniert.

Befindet sich das Halbleiterbauelement in einem leitenden Zustand, so wird die niedrigdotierte Zone 4 mit Minoritätsladungsträgern überschwemmt. Neben dem oben beschriebenen sogenannten Shockley-Read-Hall Mechanismus findet bei hinreichend hoher Injektion von Ladungsträgern dann auch eine Träger-Träger-Rekombination, auch Auger-Rekombination genannt, statt. Bei hohen Stromdichten (Ladungsträgerüberschuss grösser als etwa $10^{17}$ $cm^{-3}$) dominiert die Auger-Rekombination, sodass die Lebensdauer zusätzlich verkürzt wird auf die Augerlebensdauer $Tau_{Aug}$. Wenn das Halbleiterbauelement im leitenden Zustand ist, ist in der Regel die Augerlebensdauer $Tau_{Aug}$ beträchtlich kleiner als die Volumenlebensdauer $Tau_{SRH}$.

Wenn nun gemäss der Erfindung die charakteristische Länge a des Abschnitts geringer Trapdichte so gewählt wird, dass sie in etwa der Volumendiffusionslänge $L_{D,bulk}$ entspricht, so hat das folgende Wirkung:

Im leitenden Zustand ist die Diffusionslänge, der Minoritätsladungsträger (wegen der geringen Augerlebensdauer) wesentlich kleiner als der Abstand der Abschnitte hoher Trapdichte. Die Minoritätsladungsträger diffundieren damit weitgehend ungestört durch den axial begrenzten Bereich 6 hindurch. Die eingebrachten Rekombinationszentren bewirken keinen zusätzlichen Vorwärtsspannungsabfall.

Beim Uebergang des Halbleiterbauelements in den nichtleitenden Zustand nimmt die Diffusionslänge allmählich zu, sodass die Minoritätsladungsträger zunehmend stärker durch die Abschnitte hoher Trapdichte abgefangen werden. Im Tail-Bereich des Abschaltvorgangs, d.h. wenn die Ueberschussladungsträgerdichte wieder ausschliesslich via Shockley-Read-Hall Mechanismus reduziert wird, entspricht die Diffusionslänge der Minoritätsladungsträger im wesentlichen der Volumendiffusionslänge $L_{D,bulk}$. Die eingebauten Rekombinationszentren können damit die lebensdauerreduzierende Wirkung im Sinn eines herkömmlichen axialen Lebensdauerprofils entfalten.

Kurz gesagt führt die erfindungsgemässe, zusätzliche, laterale Struktur des Trapdichteprofils dazu, dass die Wirkung der Rekombinationszentren erst bei geringen Stromdichten bedeutsam wird. Als Folge davon ist bei dieser Methode der Lebensdauereinstellung der der Vorwärtsspannungsabfall gegenüber einem herkömmlichen axialen Lebensdauerprofil geringer, ohne dass die Abschaltcharakteristik entsprechend verschlechtert wird. Der eingangs diskutierte Trade-off zwischen Vorwärtsspannungsabfall und Abschaltzeit wird damit insgesamt besser.

Im folgenden wird nun erläutert, wie das Trapdichteprofil vorteilhaft ausgebildet werden kann. Dabei wird wieder auf die Figuren 1 und 2 Bezug genommen.

Wie bereits gesagt variiert das Trapdichteprofil periodisch in einer Ebene senkrecht zur stromführenden Achse. Das Trapdichteprofil kann dabei entweder nur in einer Richtung (eindimensional) variieren, indem es z.B. in der Art eines Steifenmusters ausgebildet ist, oder auch in zwei Richtungen (zweidimensional). Für den zweidimensionalen Fall gibt es eine Vielzahl von geeigneten Ausführungsformen. Im folgenden werden nur einige davon erwähnt.

Eine erste Variante besteht darin, dass das Trapdichteprofil in der Art eines Schachbrettmusters ausgebildet ist. Die Abschnitte geringer und diejenigen hoher Trapdichte sind hier im wesentlichen quadratisch und gleich gross.

Bei einer zweiten Variante ist das Trapdichteprofil in der Art eines Punktrasters ausgebildet. Die Abschnitte hoher Trapdichte sind Kreise, die auf den Gitterpunkten eines gedachten, rechteckigen, quadratischen oder rhombischen Gitters angeordnet sind. Die weiter oben ausführlich diskutierte, charakteristische Länge a entspricht hier im wesentlichen dem Abstand zweier benachbarter Gitterpunkte.

Im Hinblick auf die Effizienz des lateral strukturierten Trapdichteprofils ist es von Vorteil, wenn die Abschnitte geringer Trapdichte 7a, 7b,.. und die Abschnitte hoher Trapdichte 8a, 8b, flächenmässig etwa gleich gross sind.

Gemäss einer besonders bevorzugten Ausführungsform der Erfindung ändert sich das Trapdichteprofil 9 sprunghaft von Abschnitten geringer Trapdichte 7a, 7b,.. zu Abschnitten hoher Trapdichte 8a, 8b,... In den Abschnitten geringer und denjenigen hoher Trapdichte nimmt das Trapdichteprofil zudem je einen näherungsweise konstant niedrigen resp. hohen Wert an.

Der Parameter, der bei allen Ausführungsformen gleichermassen bestimmend ist, ist die Volumendiffusionslänge $L_{D,Bulk}$. Diese beträgt bei einer Lebensdauer von z.B. $Tau_{SRH}$ = 70 µs bei Zimmertemperatur ca. 300 µm in n-Typ Silizium und ca. 500 µm in p-Typ Silizium. Das Trapdichteprofil sollte demzufolge eine Periode von typischerweise einigen 100 µm haben.

Was bisher im Zusammenhang mit dem einfachen Bauelement der Fig. 1 gesagt wurde, lässt sich ohne weiteres auf kompliziertere Halbleiterbauelemente mit axialer Stromführung, wie Transistoren und Thyristoren verschiedenster Art, übertragen. Die Erfindung erfasst somit einen weiten Anwendungsbereich. Insbesondere kann sie überall dort eingesetzt werden, wo herkömmliche axiale Lebensdauerprofile Anwendung finden.

Im folgenden wird ein bevorzugtes Verfahren zum Herstellen eines erfindungsgemässen Halbleiterbauelements beschrieben.

Ausgangspunkt ist ein fertig diffundiertes und oxidiertes Halbleitersubstrat 1, welches in seinem Innern eine oder mehrere PN-Strukturen aufweist. Als erstes wird nun das Halbleitersubstrat 1 mit hochenergetischen Protonen bestrahlt, sodass in einem wohl definierten, axial begrenzten Bereich 6 Rekombinationszentren erzeugt werden. Damit dabei ein erfindungsgemässes Trapdichteprofil entsteht, wird die Bestrahlung vorzugsweise wie folgt durchgeführt.

Fig. 3 zeigt eine Vorrichtung zum Erzeugen eines axial und lateral strukturierten Trapdichteprofils. Ein Beschleuniger 10 erzeugt einen hochenergetischen Protonenstrahl 11, welcher z.B. mit einer am Ausgang des Beschleunigers 10 angeordneten Ablenkvorrichtung (Scanner) in Richtungen quer zum Protonenstrahl 11 abgelenkt werden kann. (In Fig. 3 deutet ein Doppelpfeil zumindest eine der beiden möglichen Richtungen an.) Das zu bestrahlende Halbleitersubstrat 1 ist in einer Bestrahlungsebene hinter einer erfindungsgemäss ausgebildeten Blende 12 angeordnet. Mit Hilfe der Ablenkvorrichtung wird der Protonenstrahl 11 sukzessive so über die Blende 12 und das durch die Blende 12 hindurch teilweise sichtbare Halbleitersubstrat 1 geführt, dass eine flächenhafte Bestrahlung resultiert.

Die Blende 12 ist zumindest bereichsweise gerastert, d.h. sie weist ein periodisches Muster von protonendurchlässigen und protonenundurchlässigen Bereichen 13 resp. 14 auf. Durch die protonendurchlässigen Bereiche 13 hindurch induziert der Protonenstrahl 11 in einer gewünschten, durch die Protonenenergie bestimmte Tiefe Rekombinationszentren im Halbleitersubstrat 1. Die Konzentration der induzierten Störstellen hängt dabei in bekannter Art von der Protonendosis ab.

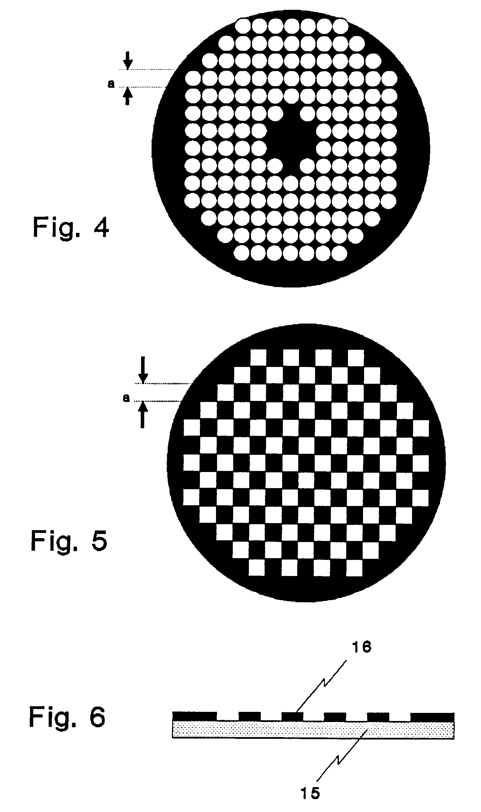

Fig. 4 zeigt eine Draufsicht auf eine Blende 12 mit einem im wesentlichen zweidimensional periodischen Lochraster. Dabei sind in einem protonenundurchlässigen Material kreisförmige, auf einem quadratischen Gitter angeordnete Bohrungen vorgesehen. Die Periode des Lochrasters (charakteristische Länge a) entspricht im wesentlichen der Volumendiffusionslänge $L_{D,Bulk}$ der zu bestrahlenden niedrigdotierten Zone 4 im Halbleitersubstrat 1. Vorzugsweise ist der Durchmesser der Bohrungen so gewählt, dass sich protonnendurchlässige und protonenundurchlässige Bereiche flächenmässig die Waage halten.

Wie aus Fig. 4 zu erkennen ist, braucht der Lochraster nicht die ganze Blende 12 flächenmässig auszufüllen. Dies ist z.B. dann der Fall, wenn die Lebensdauer der Ladungsträger nur in einem seitlich wohl begrenzten Bereich reduziert werden soll. Im vorliegenden Beispiel wird also ein zentraler Bereich von der Bestrahlung ausgenommen. Ob das Halbleitersubstrat ganzflächig oder nur in einem seitlich begrenzten Bereich bestrahlt wird, hängt grundsätzlich von der Art (innere Struktur) des implementierten Halbleiterbauelements ab.

Fig. 5 zeigt ein Blende mit einem schachbrettartigen Lochraster. Die protonendurchlässigen und die protonenundurchlässigen Bereiche sind dabei quadratisch und haben eine Seitenlänge, welche der oben diskutierten charakteristischen Länge a entspricht.

Vorzugsweise ist die Blende eine aus einem Schwermetall, z.B. Molybdän, bestehende dünne Scheibe, welche mit Bohrungen in der beschriebenen Weise versehen ist. Der Vorteil eines Schwermetalls liegt primär darin, dass die Scheibe auch bei höheren Protonenenergien von z.B. mehreren MeV so dünn gehalten werden kann, dass die seitliche Streuung des Protonenstrahls an den Kanten der Blende ("Schatten", "Abbildungsfehler") in engen Grenzen gehalten werden kann. Dies ist insbesondere dann von Bedeutung, wenn ein stufenförmiges Trapdichteprofil erzeugt werden soll. Zudem können feine Strukturen an dünnen Scheiben mechanisch einfacher realisiert werden.

Solange die Blende 12 durch eine Scheibe aus einem protonenundurchlässigen Material gebildet wird, die mit Bohrungen durchbrochen ist, sind natürlich nur solche Muster möglich, bei welchen die protonenundurchlässigen Bereiche ein zusammenhängendes Gebiet ergeben. Wenn die Blende 12 jedoch einen protonendurchlässigen Träger umfasst, so kann diese Beschränkung umgangen werden.

Fig. 6 zeigt eine Blende, bei welcher auf einem gut protonendurchlässigen Träger 15 (z.B. einer dünnen Folie aus einem Leichtmetall) ein Muster mit protonenabsorbierendem Material 16 angeordnete ist. Auf diese Weise kann auch ein Muster realisiert werden, welches zu den in Figuren 4 und 5 gezeigten invers ist.

Grundsätzlich können die gezeigten Muster in vielfältiger Art variiert werden, ohne dass die erfindungsgemässe Wirkung verloren geht. So kann das dem Lochraster zugrunde liegende Gitter auch rechteckig oder rhombisch sein. Anstatt eines Lochrasters, kann aber auch ein Streifenmuster verwendet werden. Wie auch immer das Muster ausgebildet ist, so ist es in jedem Fall gekennzeichnet durch die charakteristische Länge a resp. $L_{D,Bulk}$.

Nach der Bestrahlung folgen in der Regel noch mehrere Prozessschritte bis zur Fertigstellung des Halbleiterbauelements. Besonders vorteilhaft ist es, das bestrahlte Halbleitersubstrat 1 einer Temperung zu unterwerfen, um die Langzeitstabilität der Rekombinationszentren sicher zu stellen. Dazu wird es in einem Hochvakuum, d.h. bei einem Druck von weniger als etwa $10^{-5}$ Torr [1 Torr $\equiv$ 133.3 Pa], für mindestens 30 Minuten auf einer Temperatur zwischen 260°C und 300°C gehalten. Die genaue Zeitdauer der Temperung ergibt sich aus der gewählten Bestrahlungsdosis und der gewünschten Ladungsträger-Lebensdauer.

Nach der Temperung wird schliesslich das Halbleitersubstrat 1 einem als solchen bekannten Passivierungsprozess unterzogen, bei welchem ein oder mehrere Passivierungsschichten aufgebracht und ausgebacken werden. Dabei ist zu beachten, dass die zum Ausbacken verwendeten Temperaturen unter denjenigen der Temperung liegen, damit die Ladungsträger-Lebensdauer nicht wieder verändert wird.

Besonders vorteilhaft ist es, die Bestrahlung nach dem Passivierungsprozess durchzuführen. Dann folgen nämlich ausser dem obligatorischen Temperprozess zur thermischen Stabilisierung der Rekombinationszentren keine weiteren Heissprozesse mehr.

Eine weitere Anwendungsmöglichkeit der Erfindung ist ein Verfahren, bei welchem in das Halbleitersubstrat eindiffundierte, elektrisch inaktive Fremdatome durch Protonenbestrahlung und Temperung selektiv als Rekombinationszentren aktiviert werden. Im folgenden wird ein solches, bevorzugtes Verfahren beschrieben.

In ein Halbleitersubstrat mit einer gewünschten Dotierungsstruktur (ein oder mehrere PN-Uebergänge) werden Fremdatome eindiffundiert, welche folgende Rekombinations- und Diffusionseigenschaften haben:

1. Rekombinationsaktiv auf einem Gitterplatz
2. Rekombinationsinaktiv auf einem Zwischengitterplatz (interstitiell).
3. Diffusion erfolgt interstitiell und via Leerstellenmechanismus (d.h. dissoziativ), aber im wesentlichen nicht via Kick-out-Mechanismus.

Welche Eigenschaften ein gegebenes Fremdatom in einem bestimmten Halbleiterkristall hat, lässt sich aufgrund energetischer Ueberlegungen eruieren.

Fremdatome mit diesen Eigenschaften in einem Siliziumkristall sind z.B. Cu-, Ag oder Pd-Atome. Ag hat gegenüber Cu den Vorteil, dass es nur eine geringe Tendenz zur Komplexbildung hat. Im folgenden wird das Verfahren am Beispiel Ag in Si erläutert.

Nach der Eindiffusion, welche ein Konzentrationsprofil von interstitiellen und somit elektrisch inaktiven Fremdatomen, im vorliegenden Beispiel Ag, ergibt, folgt eine erfindungsgemässe Protonenbestrahlung, welche in einem axial begrenzten Bereich zu einem lateral strukturierten Leerstellenprofil führt. Das Leerstellenprofil muss dabei im wesentlichen mit dem Konzentrationsprofil räumlich zusammenfallen.

Wenn nun das Halbleiterbauelement einer Temperung unterworfen wird, dann läuft in der durch die Bestrahlung erzeugten Defektzone der Prozess Ag(int) + Vac --> Ag(sub) ab, d.h. das interstitielle Ag diffundiert auf die Leertellen (Vacancy) und wird elektrisch aktiv. Das durch die Bestrahlung erzeugte Leerstellenprofil wird in ein Konzentrationsprofil von substitutionellem Ag umgewandelt.

Gegenüber den Leerstellen, wie sie bei alleiniger Anwendung von Bestrahlung erzeugt werden, ist substitutionelles Ag bezüglich Rekombination um etwa einen Faktor 10 effektiver.

Abschliessend kann gesagt werden, dass durch erfindungsgemässe axiale und laterale Lebensdauerstrukturierung der Trade-off zwischen Vorwärtsspannungsabfall und Abschaltzeit bei einer grossen Zahl von Halbleiterbauelementen grosser Leistung wesentlich verbessert werden kann.

**BEZEICHNUNGSLISTE**

1 - Halbleitersubstrat; 2 - hochdotierte Zone; 3 - Hauptfläche; 4 - niedrigdotierte Zone; 5 - PN-Uebergang; 6 - axial begrenzter Bereich; 7a, 7b - Abschnitte hoher Trapdichte; 8a, 8b - Abschnitte geringer Trapdichte; 9 - Trapdichteprofil; 10 - Beschleuniger; 11 - Protonenstrahl; 12 - Blende; 13 - protonendurchlässiger Bereich; 14 - protonenundurchlässiger Bereich; 15 - Träger ; 16 - protonenabsorbierendes Material; a - charakteristische Länge; $N_t$ - Trapdichte; x - Ort.

**Patentansprüche**

1. Halbleiterbauelement, welches von einem leitenden in einen nichtleitenden Zustand schalten kann, umfassend

a) eine dotierte Zone mit Minoritätsträgern, welche im nichtleitenden Zustand eine gegebene mittlere Volumenlebensdauer $Tau_{SRH}$ und damit eine mittlere Volumendiffusionslänge $L_{D,Bulk}$ haben und im leitenden Zustand, bei welchem die dotierte Zone mit Minoritätsladungsträgern in einer axialen Richtung überschwemmt wird, eine aufgrund der Auger-Rekombination verkürzte Lebensdauer $Tau_{Aug}$ haben, und

b) einen axial begrenzten Bereich in der dotierten Zone, in welchem Rekombinationszentren zum Reduzieren der mittleren Volumenlebensdauer $Tau_{SRH}$ der Minoritätsladungsträger vorhanden sind, dadurch gekennzeichnet, dass

c) die Rekombinationszentren ein quer zur axialen Richtung periodisch variierendes Trapdichteprofil bilden, bei welchem sich Abschnitte geringer Trapdichte mit Abschnitten hoher Trapdichte mit einer etwa der Volumendiffusionslänge $L_{D,Bulk}$ entsprechenden Periode abwechseln, und

d) der Bereich, in welchem sich das Trapdichteprofil befindet, axial in beiden Richtungen begrenzt ist.

**2.** Halbleiterbauelement nach Anspruch 1, dadurch gekennzeichnet, dass die Rekombinationszentren quer zur axialen Richtung ein zweidimensional periodisch variierendes Trapdichteprofil bilden.

**3.** Halbleiterbauelement nach Anspruch 1, dadurch gekennzeichnet, dass das Trapdichteprofil
a) in Abschnitten geringer Trapdichte und in Abschnitten hoher Trapdichte je näherungsweise einen konstant niedrigen resp. konstant hohen Wert annimmt und
b) sich von Abschnitten geringer Trapdichte zu Abschnitten hoher Trapdichte sprunghaft ändert.

**4.** Halbleiterbauelement nach Anspruch 3, dadurch gekennzeichnet, dass die Abschnitte geringer Trapdichte und die Abschnitte hoher Trapdichte flächenmässig etwa gleich gross sind.

**5.** Halbleiterbauelement nach Anspruch 1, dadurch gekennzeichnet, dass die dotierte Zone in axialer Richtung an eine hochdotierte, Minoritätsladungsträger injizierende Zone grenzt und mit dieser einen schnell schaltenden PN-Uebergang bildet.

**Claims**

**1.** Semiconductor element that can switch from a conducting into a non-conducting state, comprising
a) a doped zone having minority charge carriers, which in the non-conducting state have a given mean bulk lifetime $Tau_{SRH}$ and thus a mean bulk diffusion length $L_{D,Bulk}$ and in the conducting state, in which the doped zone is swamped by minority charge carriers in one axial direction, have a shortened lifetime $Tau_{Aug}$ by virtue of the Auger recombination, and
b) an axially limited region in the doped zone in which recombination centres for reducing the mean bulk lifetime $Tau_{SRH}$ of the minority charge carriers are present,
characterised in that
c) the recombination centres form a trap density profile varying periodically transverse to the axial direction, in which segments of low trap density alternate with segments of high trap density with a period corresponding approximately to the bulk diffusion length $L_{D,Bulk}$, and
d) the region in which the trap density profile is located is axially limited in both directions.

**2.** Semiconductor component according to Claim 1, characterised in that transverse to the axial direction the recombination centres form a two-dimensionally periodically varying trap density profile.

**3.** Semiconductor component according to Claim 1, characterised in that
a) in segments of low trap density and in segments of high trap density the trap density profile respectively approximately assumes a constantly low or constantly high value, and
b) the change from segments of low trap density to segments of high trap density takes place abruptly.

**4.** Semiconductor component according to Claim 3, characterised in that the segments of low trap density and the segments of high trap density are approximately of the same size in terms of area.

**5.** Semiconductor component according to Claim 1, characterised in that in the axial direction the doped zone adjoins a highly doped zone that injects minority charge carriers, and forms with said zone a rapidly switching p-n junction.

**Revendications**

**1.** Elément semi-conducteur, lequel peut commuter d'un état conducteur à un état non conducteur, comprenant
a) une zone dopée avec porteurs minoritaires, lesquels dans l'état non conducteur ont une durée de vie volumétrique moyenne donnée $Tau_{SRH}$ et par conséquent une longueur de diffusion volumétrique $L_{D,bulk}$ et dans l'état non conducteur dans lequel la zone dopée est submergée de porteurs minoritaires de charge dans une direction axiale, et sur base de quoi ils ont une durée de vie raccourcie de la recombinaison d'Auger $Tau_{Aug}$, et
b) un domaine axial limité dans la zone dopée, dans lequel les centres de recombinaison pour la réduction de la durée de vie volumétrique moyenne $Tau_{SRH}$ du porteur minoritaire de charge sont disponibles, ainsi caractérisé par le fait que

7

c) les centres de recombinaison forment un profil de densités de lacunes variant périodiquement transversalement par rapport à la direction axiale, dans lesquels alternent des segments de faible densité de lacunes avec des segments de haute densité de lacunes avec une période correspondante à la longueur de diffusion volumétrique $L_{D,bulk}$, et

d) le domaine axial dans lequel se trouve le profil de densités de lacunes est limité axialement dans les deux directions.

2. Elément semi-conducteur de la revendication 1, caractérisé par le fait que les centres de recombinaison forment un profil de densités de lacunes bidimensionnel variant périodiquement transversalement par rapport à la direction axiale.

3. Elément semi-conducteur de la revendication 1, caractérisé par le fait que le profil de densités de lacunes :
a) prenne une valeur approximativement constante faible et élevée respectivement dans les segments de faible densité de lacunes et dans les segments de haute densité de lacunes, et
b) change de manière discontinue des densités faibles de lacunes aux densités hautes de lacunes.

4. Elément semi-conducteur de la revendication 3, caractérisé par le fait que les segments de faible densité de lacunes et les segments de haute densité de lacunes soient environ de la même taille par unité de surface.

5. Elément semi-conducteur de la revendication 1, caractérisé par le fait que la zone dopée aboutisse à une zone surdopée injectée de porteurs minoritaires de charge et ainsi forme une jonction PN à commutation rapide.

Fig. 1

Fig. 2

Fig. 3

Fig. 4

Fig. 5

Fig. 6